# DEMANDE DE BREVET EUROPEEN

(11) **EP 3 832 707 A1**
(43) Date de publication de la demande: **09.06.2021**
(21) Numéro de dépôt: 20212061.4
(22) Date de dépôt: 04.12.2020
(51) Int. Cl.: H01L 21/768, H01L 45/00, H01L 27/24

(54) **STRUCTURE D'INTERCONNEXION D'UN CIRCUIT INTÉGRÉ**

(30) Priorité: 06.12.2019 FR 1913902
(71) Demandeur: Commissariat à l'Energie Atomique et aux Energies Alternatives, 75015 Paris (FR)
(72) Inventeur: BRUN, Philippe, 38054 GRENOBLE CEDEX 9 (FR); REYNARD, Jean-Philippe, 38000 GRENOBLE (FR); DEL MEDICO, Sylvie, 38920 CROLLES (FR)
(74) Mandataire: Cabinet Beaumont

(57) **Abrégé**

La présente description concerne un procédé comprenant les étapes suivantes : prévoir un circuit intégré (1) comprenant : un empilement de première (5), deuxième (7) et troisième (9) couches isolantes ; des contacts (11) traversant la première couche (5) ; et un composant (13) comprenant une région de contact électrique (15) dans la deuxième couche (7) ; graver une ouverture (35) dans la troisième couche (9), à l'aplomb de la région de contact (15) ; déposer une quatrième couche isolante (37) remplissant l'ouverture (35) ; graver une autre ouverture (43) jusqu'à la région de contact (15) en passant par l'ouverture (35) dans la troisième couche isolante (9) ; et former un niveau de métal en remplissant l'autre ouverture d'un métal (45).

## Description

### Domaine technique

La présente description concerne de façon générale les circuits intégrés, et plus particulièrement les structures d'interconnexion des circuits intégrés et les procédés de fabrication de ces structures d'interconnexion.

### Technique antérieure

On connaît des circuits intégrés comprenant une couche semiconductrice, un empilement de couches isolantes reposant sur la couche semiconductrice et une structure d'interconnexion reposant sur l'empilement de couches isolantes. Ces circuits comprennent des vias de contact électrique reposant sur et en contact avec des zones de contact électrique formées à partir de la couche semiconductrice et traversant une partie de l'empilement de couches isolantes, et au moins un composant électronique comprenant une région de contact électrique disposée à un niveau intermédiaire de l'empilement de couches isolantes, entre le niveau des sommets des vias de contact électrique et le premier niveau de métal de la structure d'interconnexion, c'est-à-dire le niveau de métal le plus proche de la couche semiconductrice.

### Résumé de l'invention

Dans les circuits intégrés décrits ci-dessus, les connexions électriques connues entre le premier niveau de métal et des régions de contact électrique disposées entre le niveau du sommet des vias de contact et le premier niveau de métal présentent divers inconvénients. Les procédés de fabrication de ces connexions électriques connues présentent également divers inconvénients.

Il existe un besoin de pallier tout ou partie des inconvénients de ces connexions électriques connues et/ou de leurs procédés de fabrication.

Un mode de réalisation pallie tout ou partie des inconvénients des connexions électriques connues telles que décrites précédemment.

Un mode de réalisation pallie tout ou partie des inconvénients des procédés de fabrication connus de connexions électriques entre le premier niveau de métal d'une structure d'interconnexion et une région de contact électrique telle que décrite précédemment.

Un mode de réalisation prévoit un procédé de fabrication d'une structure d'interconnexion comprenant les étapes successives suivantes :
a) prévoir un circuit intégré comprenant : une première couche isolante ; une deuxième couche isolante reposant sur la première couche ; une troisième couche isolante reposant sur la deuxième couche ; des contacts électriques, de préférence des vias de contact électrique, traversant la première couche ; des premiers vias électriquement conducteurs traversant la deuxième couche isolante et s'étendant depuis un via de contact électrique correspondant jusqu'à ladite troisième couche ; et un composant, de préférence un point mémoire d'une mémoire à changement de phase, une région de contact électrique du composant étant située dans la deuxième couche et étant recouverte par une partie de cette deuxième couche;
b) graver une première ouverture à travers la troisième couche et à l'aplomb de la région de contact, la gravure de la première ouverture étant stoppée avant la région de contact ;
c) déposer une quatrième couche isolante de sorte à remplir la première ouverture et à recouvrir la troisième couche ;
d) graver une deuxième ouverture à travers la quatrième couche jusqu'à la région de contact de sorte que la deuxième ouverture passe à travers la troisième couche isolante au niveau de la première ouverture ; et
e) former un niveau de métal de la structure d'interconnexion en remplissant la deuxième ouverture d'au moins un métal.

Selon un mode de réalisation, à l'étape a), les contacts électriques ont des sommets situés en dessous de la deuxième couche isolante.

Selon un mode de réalisation, des troisièmes ouvertures sont gravées en même temps que la deuxième ouverture à l'étape d), chaque troisième ouverture étant gravée à l'aplomb d'un des premiers vias et jusqu'audit premier via.

Selon un mode de réalisation, l'étape d) comprend le dépôt d'une première couche de résine photosensible et l'alignement d'un masque d'insolation de la première couche de résine avec lesdits premiers vias.

Selon un mode de réalisation, à l'étape a), une cinquième couche isolante recouvre la région de contact, et, à l'étape d), la gravure de la deuxième ouverture comprend une première gravure jusqu'à ladite cinquième couche suivie d'une deuxième gravure à travers la cinquième couche et jusqu'à la région de contact.

Selon un mode de réalisation, la première gravure est sélective par rapport à la troisième couche isolante et à la cinquième couche isolante.

Selon un mode de réalisation, à l'étape d), les troisièmes ouvertures sont gravées jusqu'à la troisième couche lors de la première gravure, puis jusqu'aux premiers vias lors de la deuxième gravure.

Selon un mode de réalisation, l'étape b) comprend le dépôt d'une deuxième couche de résine photosensible et l'alignement d'un masque d'insolation de la deuxième couche de résine avec ladite région de contact.

Selon un mode de réalisation, la première ouverture à des dimensions latérales inférieures à des dimensions latérales correspondantes de la région de contact.

Selon un mode de réalisation, l'étape e) comprend le dépôt dudit au moins un métal de manière à remplir la deuxième ouverture et à recouvrir la quatrième couche isolante, et une étape de polissage mécano chimique jusqu'à la quatrième couche isolante.

Selon un mode de réalisation, à l'étape a), la première couche isolante repose sur une couche semiconductrice, de préférence munie de zones de contact électrique en contact avec des contacts électriques correspondants.

Selon un mode de réalisation, à l'étape a), la région de contact électrique du composant est une région de contact supérieure, le composant comprenant en outre une région de contact inférieure située à l'aplomb de la région de contact supérieure, la région de contact inférieure étant en contact avec un sommet d'un desdits contacts électriques.

Un autre mode de réalisation prévoit un circuit intégré comprenant :
une première couche isolante ;
une deuxième couche isolante reposant sur la première couche ;
une troisième couche isolante reposant sur la deuxième couche ;
des contacts électriques, de préférence des vias de contact électrique, traversant la première couche ;
un composant, de préférence un point mémoire d'une mémoire à changement de phase, le composant comprenant une région de contact électrique supérieure située dans la deuxième couche en dessous du niveau de la face supérieure de la deuxième couche, et une région de contact électrique inférieure en contact avec un sommet d'un des vias de contact électrique ;
une quatrième couche isolante reposant sur une face supérieure de la troisième couche isolante ; et
un premier niveau de métal d'une structure d'interconnexion du circuit comprenant une portion s'étendant depuis une face supérieure de la quatrième couche jusqu'à la région de contact électrique supérieure et reposant en partie sur et en contact avec la deuxième couche isolante, de préférence sur et en contact avec un épaulement défini par la deuxième couche isolante, le premier niveau de métal étant le niveau de métal de la structure d'interconnexion le plus proche d'une couche semiconductrice du circuit.

Selon un mode de réalisation, le premier niveau de métal est obtenu en mettant en oeuvre le procédé décrit.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente par une vue schématique et en coupe, un circuit intégré à une étape d'un mode de mise en oeuvre d'un procédé de fabrication d'une structure d'interconnexion du circuit intégré ;
la figure 2 représente par une vue schématique et en coupe, le circuit de la figure 1 à une autre étape du procédé de fabrication ;
la figure 3 représente par une vue schématique et en coupe, le circuit de la figure 2 à une autre étape du procédé de fabrication ;
la figure 4 représente par une vue schématique et en coupe, le circuit de la figure 3 à une autre étape du procédé de fabrication ;
la figure 5 représente par une vue schématique et en coupe, le circuit de la figure 4 à une autre étape du procédé de fabrication ;
la figure 6 représente par une vue schématique et en coupe, le circuit de la figure 5 à une autre étape du procédé de fabrication ;
la figure 7 représente par une vue schématique et en coupe, le circuit de la figure 6 à une autre étape du procédé de fabrication ; et
la figure 8 représente par une vue schématique et en coupe, le circuit de la figure 7 à une autre étape du procédé de fabrication.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les composants électroniques usuels des circuits intégrés n'ont pas été détaillés, les modes de réalisation, les variantes de réalisation, les modes de mise en oeuvre, et les variantes de mise en oeuvre décrits étant compatibles avec ces composants électroniques usuels ainsi qu'avec les procédés de fabrication de ces composants usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

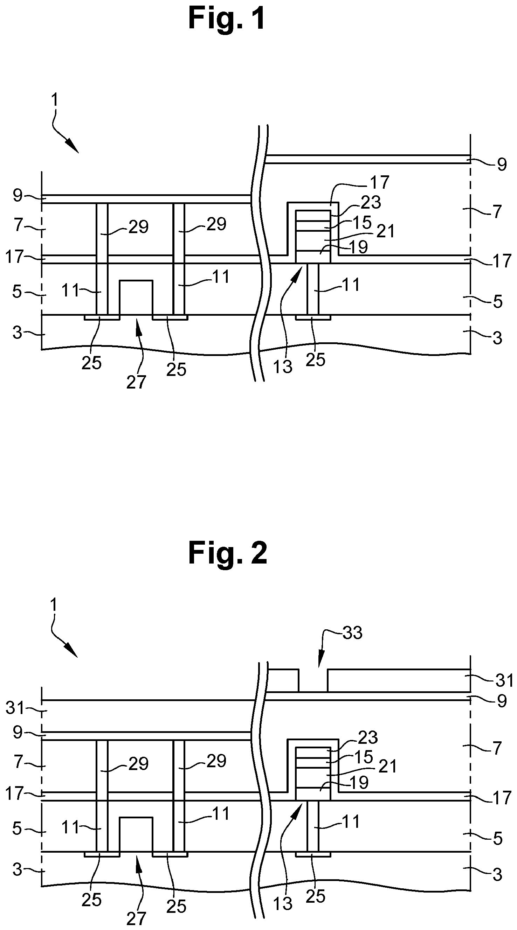

La figure 1 représente par une vue schématique et en coupe, un circuit intégré 1 à une étape d'un mode de mise en oeuvre d'un procédé de fabrication d'une structure d'interconnexion du circuit intégré 1.

Le circuit intégré 1 comprend une couche semiconductrice 3, par exemple en silicium. La couche 3 peut être un substrat semiconducteur. La couche semiconductrice 3 peut également être une couche semiconductrice reposant sur une couche isolante reposant elle-même sur un support, la couche 3 étant alors couramment appelée couche SOI ("Semiconductor On Insulator" - semiconducteur sur isolant).

Le circuit 1 comprend une couche isolante 5 reposant sur la couche semiconductrice 3, de préférence en contact avec la couche 3. De préférence, une face supérieure de la couche 5, c'est-à-dire une face de la couche 5 opposée à la couche 3, est plane. La couche 5 est par exemple constituée d'une unique couche isolante ou d'un empilement de plusieurs couches isolantes, éventuellement en des matériaux différents. A titre d'exemple, la couche 5 comprend une couche de nitrure de silicium (non détaillée en figure 1) reposant sur et en contact avec la couche 3, et une couche d'oxyde de silicium (non détaillée en figure 1) reposant sur et en contact avec la couche de nitrure de silicium.

Le circuit 1 comprend une couche isolante 7 reposant sur la couche 5. La couche 7 est par exemple constituée d'une unique couche isolante ou d'un empilement de plusieurs couches isolantes, éventuellement en des matériaux différents. A titre d'exemple, la couche 7 est une unique couche d'oxyde de silicium (SiO₂).

Le circuit 1 comprend une couche isolante 9 reposant sur la couche 7, de préférence en contact avec la couche 7. A l'étape de la figure 1, la couche 9 a une face supérieure, c'est-à-dire une face opposée à la couche 3, exposée.

Selon un mode de réalisation, la couche 9 est une couche barrière de diffusion et/ou une couche d'arrêt de gravure.

A titre d'exemple, la couche 9 est une couche de nitrure de carbone silicium ou carbonitrure de silicium (SiCN), ou une couche de de nitrure de silicium (SiN), de préférence une couche de SiCN.

Le circuit 1 comprend des vias de contact électrique, ou contacts électriques, 11 s'étendant à travers la couche 5. De préférence, comme cela est représenté en figure 1, les contacts électriques 11 ne pénètrent pas dans la couche isolante 7. Dit autrement, le niveau supérieur des contacts électriques 11 est situé sous le niveau de la face inférieure de la couche 7. Dit encore autrement, les sommets des contacts électriques 11 sont situés en-dessous de la couche 7. De préférence, comme cela est représenté en figure 1, les contacts électriques 11 affleurent la face supérieure de la couche isolante 5. A titre d'exemple, les contacts électriques 7 sont en tungstène (W).

Le circuit 1 comprend un composant électronique 13. Le composant 13 comprend une région de contact électrique, ou électrode, 15. L'électrode 15 est située à un niveau intermédiaire de la couche 7. Dit autrement, l'électrode 15 est donc disposée ou enterrée dans la couche 7, au-dessus du niveau de la face inférieure de la couche 7 et en dessous du niveau d'une portion de la face supérieure de la couche 7 au-dessus de l'électrode 15, une partie de l'épaisseur de la couche 7 recouvrant alors l'électrode 15. Dit encore autrement, l'électrode 15 est située sous la couche 9, séparée de cette dernière par une portion de la couche 7, et est située au-dessus du niveau des sommets des contacts électriques 11. A titre d'exemple, l'électrode 15 est en nitrure de titane (TiN) ou en nitrure de tantale (TaN).

Selon un mode de réalisation, l'électrode 15 est recouverte d'une couche isolante 17, par exemple en nitrure de silicium (SiN) ou en nitrure de carbone silicium (SiCN), de préférence en SiN. Dans cet exemple, une couche isolante 23 est intercalée entre l'électrode 15 et la couche 17, ou, dit autrement, la couche 23 repose sur et en contact avec l'électrode 15 et la couche 17 repose sur et en contact avec la couche 23. La couche 23 est par exemple en SiN ou en SiCN, de préférence en SiN. La couche 23 a par exemple, en vue de dessus, la même surface que l'électrode 15 qu'elle recouvre. Cela résulte par exemple du fait que la couche 23 correspond à un masque dur utilisé pour définir par gravure l'électrode 15 dans une couche du matériau de l'électrode 15. Dans l'exemple représenté, la couche 17 recouvre également les flancs du composant 13, notamment les flancs de la couche 23, et repose, de part et d'autre du composant 13, sur la couche 5, de préférence en contact avec la couche 5. Dans cet exemple, la couche 7 repose sur en contact avec la couche 17. La couche 17 est de préférence une couche barrière de diffusion et/ou une couche d'arrêt de gravure. En particulier, dans cet exemple où la couche 17 recouvre la couche 5 de part et d'autre du composant 13, cette couche 17 sert de couche de barrière de diffusion du matériau des contacts électriques 11.

Dans l'exemple représenté, le composant 13 est un point mémoire d'une mémoire à changement de phase, par exemple d'une mémoire de type PCRAM ("Phase Change Ramdom Access Memory" - Mémoire à accès aléatoire à changement de phase). Dans cet exemple, le composant 13 comprend un empilement comportant successivement, du bas vers le haut en figure 1, une région de contact électrique inférieure, ou électrode inférieure, 19, un matériau à changement de phase 21, par exemple un alliage de type GST, l'électrode 15 formant l'électrode supérieure du composant 13, et la couche isolante 23. De préférence, les couches 19, 21, 15 et 23 de l'empilement du composant 13 sont auto-alignées, la couche 23 correspondant par exemple au masque dur de la gravure ayant permis de définir le composant 13. L'électrode inférieure 19 est en contact avec le sommet d'un contact électrique 11. On notera que l'électrode 15 peut être en un matériau autre que du TaN ou du TiN, notamment, dans le cas d'un point mémoire 13 d'une mémoire à changement de phase, en un matériau comprenant du métal et dont le dépôt, par exemple un dépôt chimique en phase vapeur, est compatible avec le dépôt du matériau à changement de phase 21.

Le circuit 1 comprend des zones de contact, ou zones de reprise de contact, notamment des zones de contact 25 formées à partir de la couche 3, par exemple par siliciuration de portions de la couche 3, ou de portion de zones épitaxiées à partir de la couche 3. Dit autrement, la couche 3 est munie de zones de contact 25. Chaque zone de contact 25 de la couche 3 est associée à un contact électrique 11 correspondant, le pied, ou base, du contact 11 étant alors en contact avec la zone 25.

Selon un mode de réalisation, comme cela est représenté en figure 1, le circuit 1 comprend en outre des composants électroniques 27 formés dans et/ou sur la couche 3. Dans l'exemple de la figure 1, un seul composant 27 est représenté, à savoir un transistor MOS ("Metal Oxyde Semiconductor" - métal oxyde semiconducteur). Les composants 27 comprennent des zones de contact, notamment des zones de contact 25 de la couche 3. Par exemple, le transistor 27 de la figure 1 comprend une zone de contact 25 de drain, et une zone de contact 25 de source. Bien que cela ne soit pas illustré en figure 1, les composants 27 peuvent comprendre des zones de contact autres que des zones de contact de la couche 3, par exemple situées à un niveau intermédiaire de la couche 5, c'est-à-dire que ces zones de contact sont au-dessus du niveau de la face inférieure de la couche 5, et en dessous du niveau de la face supérieure de la couche 5, une portion de l'épaisseur de la couche 5 recouvrant alors cette zone de contact. Par exemple, le transistor 27 comprend une zone de contact de grille (non représentée) à un niveau intermédiaire de la couche 5, un contact électrique similaire aux contacts électriques 11, de préférence formé en même temps que les contacts 11, ayant alors sa base en contact avec la zone de contact de grille du transistor 27, et son sommet au même niveau que les sommets des contacts 11.

Comme cela est représenté en figure 1, lorsque le circuit 1 comprend une première partie avec des composants 13 (à droite en figure 1) et une deuxième partie avec des composants 27 (à gauche en figure 1), la face supérieure de la couche 9 peut présenter une différence de niveau entre ces deux parties (séparées de manière schématique par un double trait courbe en figure 1). En particulier, la face supérieure de la couche 9 peut être à un premier niveau dans la première partie et à un deuxième niveau inférieur au premier niveau dans la deuxième partie. A titre d'exemple, la différence de niveau entre les deux parties du circuit 1 est par exemple comprise entre 0 nm et 30 nm, par exemple égale ou sensiblement égale à 15 nm.

Selon un mode de réalisation, le circuit 1 comprend des vias conducteurs électriquement 29. Ces vias 29 traversent la couche 7 pour faire contact avec le sommet de contact électrique 11. Dit autrement, les vias 29 pénètrent dans la couche 7 depuis sa face supérieure, jusqu'à des contacts 11 correspondant. De préférence, les vias 29 affleurent la face supérieure de la couche 7, leurs sommets étant alors revêtus de la couche 9 qui peut donc servir de couche barrière de diffusion au matériau des vias 29. A titre d'exemple, les vias 29 sont en tungstène (W), en cobalt (Co) ou en cuivre (Cu), de préférence en tungstène.

Le procédé décrit dans la suite en relation avec les figures 2 à 8, vise à former un premier niveau de métal d'une structure d'interconnexion du circuit 1, c'est-à-dire le niveau de métal de la structure d'interconnexion le plus proche de la couche 3, ou, dit autrement, le niveau de métal de la structure d'interconnexion le plus proche des régions de contact 15 et/ou des zones de contact 25.

Dans la présente description, l'expression "niveau de métal d'une structure d'interconnexion" signifie un ensemble de portions d'une même couche métallique disposées à un même niveau dans la structure d'interconnexion, la couche métallique étant par exemple constituée d'une seule couche métallique ou de plusieurs couches métalliques éventuellement en des matériaux différents. En outre, l'expression "structure d'interconnexion" signifie un ensemble de portions de couches métalliques noyées dans des couches isolantes et reliées entre elles par des vias conducteurs traversant ces couches isolantes, les portions de couches métalliques étant organisées en plusieurs niveaux de métal.

Plus particulièrement, le procédé décrit dans la suite vise à former le premier niveau de métal de la structure d'interconnexion d'un circuit du type du circuit 1 de la figure 1, ainsi que des connexions électriques entre ce premier niveau de métal et des électrodes 15, voire également des connexions électriques entre ce premier niveau de métal avec des vias 29, afin de relier électriquement les composants électroniques 13, voire également 27, du circuit à la structure d'interconnexion.

La figure 2 représente le circuit 1 de la figure 1 à une étape d'un mode de mise en oeuvre d'un tel procédé.

Un masque de gravure 31 a été formé sur la couche 9, le masque 31 comprenant des ouvertures 33 (une seule ouverture 33 étant visible en figure 2) en vis-à-vis de chaque électrode 15 d'un composant 13. De préférence, les dimensions latérales de l'ouverture 33, par exemple mesurées dans un plan parallèle à la surface supérieure de la couche 3, sont inférieures à celle de l'électrode 15.

Bien que cela ne soit pas visible en figure 2, en vue de dessus, l'électrode 15 peut avoir une forme allongée (par exemple selon une direction orthogonale au plan de la figure 2), par exemple une forme sensiblement rectangulaire. Dans ce cas, au-dessus de l'électrode 15 du composant 13, on peut prévoir une ou plusieurs ouvertures 33. Par exemple, on peut prévoir une ouverture 33 allongée selon la direction longitudinale de l'électrode 15 en vue de dessus, par exemple pour former une connexion électrique entre le premier niveau de métal et l'électrode 15 ayant la forme d'une ligne métallique. Selon un autre exemple, on peut prévoir plusieurs ouvertures 33, par exemple sensiblement circulaires, alignées dans la direction longitudinale de l'électrode 15 en vue de dessus, par exemple pour former plusieurs connexions électriques entre le premier niveau de métal et l'électrode 15 ayant la forme de plusieurs vias conducteurs.

Le masque 31 et les ouvertures 33 qu'il comprend sont obtenus en déposant une ou plusieurs couches de résine photosensible, en insolant la résine avec un masque d'insolation, et en développant la résine insolée. Selon un mode de réalisation, le masque d'insolation est aligné avec l'électrode 15. On aurait pu penser aligner ce masque d'insolation avec les vias 29, mais cela aurait conduit à des erreurs d'alignement plus importantes entre l'ouverture 33 et l'électrode 15, ce qui n'est pas souhaitable.

Selon un exemple de mode de réalisation, le masque 31 comporte trois couches de résines, à savoir une couche de résine carbonée, une couche de résine anti-reflet, et une couche de résine photosensible. Les ouvertures 33 sont alors définies à travers ces couches de résines.

Selon une variante de réalisation, le masque 31 correspond à une ou plusieurs couches de masque dur déposées avant la ou les couches de résines, les ouvertures 33 étant gravées dans le masque dur 31 à partir d'ouvertures correspondantes préalablement formées dans la ou les couches de résines reposant sur le masque dur 31. A titre d'exemple, le masque dur 31 comprend une couche de nitrure de titane (TiN), une couche de nitrure de silicium (SiN) ou une couche carbonée.

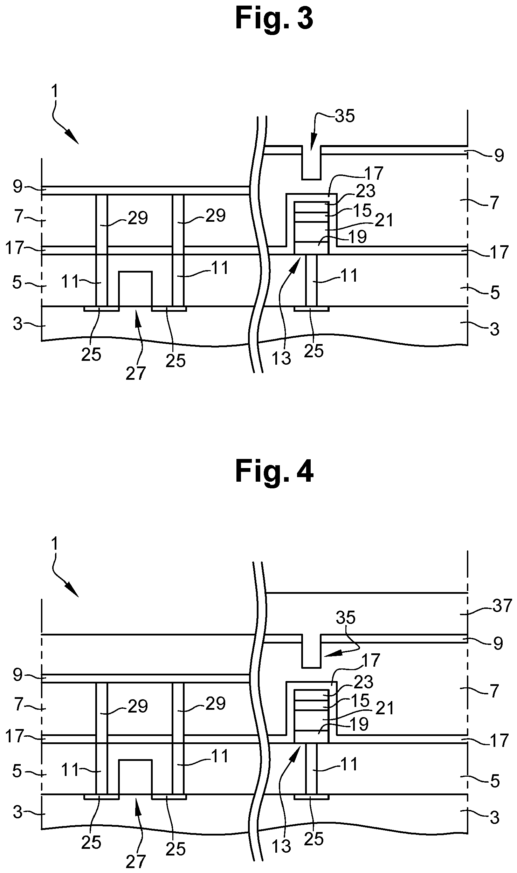

La figure 3 représente le circuit 1 de la figure 2 à une étape suivante du procédé.

Une ouverture 35 a été gravée à travers la couche 9, à l'aplomb de l'électrode 15. Plus particulièrement, l'ouverture 35 est gravée à partir d'une ouverture 33 du masque 31 (figure 2), puis le masque 31 a été retiré.

La gravure de l'ouverture 35 peut être arrêtée sur la couche 7, ou comme cela est représenté en figure 3, dans la couche 7. De préférence, quand la couche 9 présente une différence de niveau entre la première partie du circuit 1 comprenant les composants 13 et la deuxième partie du circuit 1 comprenant les composants 27, l'ouverture 35 pénètre dans la couche 7 de manière à rattraper, ou compenser, cette différence de niveau à des étapes ultérieures de gravure.

Bien que cela ne soit illustré, la gravure de l'ouverture 35 peut être arrêtée sur la couche 17 recouvrant l'électrode 15 du composant 13.

A titre d'exemple, l'ouverture 35 a une profondeur comprise entre 30 nm et 50 nm, par exemple égale à 40 nm, la profondeur de l'ouverture étant par exemple mesurée depuis la surface supérieure de la couche 9 jusqu'au fond de l'ouverture 35.

L'ouverture 35 a avantageusement des dimensions latérales, par exemple mesurées dans un plan parallèle à la face supérieure de la couche 3, inférieures à celles de l'électrode 15. Cela résulte notamment du fait que la couche 9 est fine ou peu épaisse, c'est-à-dire qu'elle a une épaisseur par exemple comprise entre 10 nm et environ 20 nm, par exemple égale ou sensiblement égale à 20 nm.

La figure 4 représente le circuit 1 de la figure 3 à une étape suivante du procédé.

Une couche isolante 37 a été déposée de manière à remplir l'ouverture 35 et à recouvrir la couche 9. La couche 37 correspond à une couche isolante de la structure d'interconnexion du circuit 1. La couche 37 est par exemple constituée d'une unique couche isolante ou d'un empilement de plusieurs couches isolantes, éventuellement en des matériaux différents. Une étape de polissage mécano-chimique ou CMP ("Chemical Mechanical Polishing") de la couche 37 est éventuellement mise en œuvre.

A titre d'exemple, la couche 37 est en oxycarbure de silicium (SiOC). Selon un autre exemple, la couche 37 comprend une couche inférieure reposant sur, et de préférence en contact avec, la couche 9, et une couche supérieure reposant sur cette couche inférieure, la couche supérieure étant généralement en un matériau de constante diélectrique inférieure à celle du matériau de la couche inférieure, par exemple en un matériau de constante diélectrique inférieure à 2,6, par exemple égale à 2,5.

A titre d'exemple, pour une technologie de circuit intégré donnée, la couche 37 a une épaisseur comprise entre 150 nm et 200 nm, par exemple égale ou sensiblement égale à 175 nm.

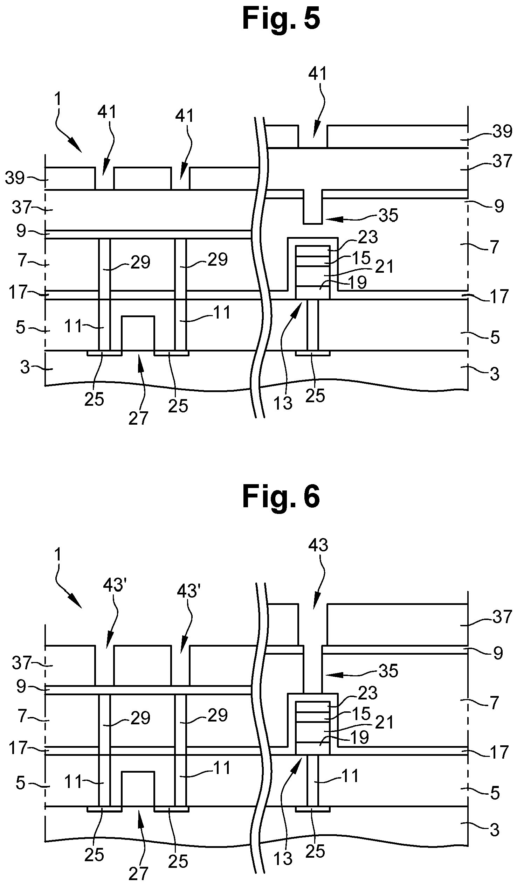

La figure 5 représente le circuit 1 de la figure 4 à une étape suivante du procédé.

Un masque de gravure 39 a été formé sur la couche 37, le masque 39 comprenant une ouverture 41 en vis-à-vis de l'ouverture 35 remplie de la couche 37, ou, dit autrement, en vis-à-vis de l'électrode 15. En outre, dans le cas où le circuit 1 comprend des vias 29, le masque 39 comprend également des ouvertures 41 en vis-à-vis des vias 29.

Bien que cela ne soit pas visible en figure 5, en vue de dessus, une même ouverture 41 peut comprendre plusieurs parties chacune en regard d'une ouverture 35 différente.

Le masque 39 et les ouvertures 41 qu'il comprend sont obtenus en déposant une couche de résine photosensible, en insolant la résine avec un masque d'insolation, et en développant la résine insolée. Selon un mode de réalisation, le masque d'insolation est aligné avec les vias 29.

Bien que cela ne soit pas détaillé ici, le masque 39 peut correspondre à une couche de résine avec des ouvertures 41, ou à au moins une couche déposée avant la résine et à travers laquelle sont gravées les ouvertures 41 à partir d'ouvertures correspondantes formées dans la résine, une telle couche étant généralement appelée couche de masque dur.

Selon un mode de réalisation, le masque 39 comprend une couche de masque dur, par exemple une couche de nitrure de titane (TiN).

La figure 6 représente le circuit 1 de la figure 5 à une étape suivante du procédé.

Une ouverture 43 a été gravée à travers la couche 37 à partir de l'ouverture 41 du masque 39 (figure 5) en vis-à-vis de l'électrode 15, et des ouvertures 43' ont été gravées simultanément à partir des ouvertures 41 du masque 39 (figure 5) en vis-à-vis des vias 29. Le masque 39 a ensuite été retiré.

La gravure est sélective par rapport à la couche 9 et à la couche 17, ou, dit autrement, est sélective par rapport au matériau de la couche 9 et au matériau de la couche 17. A titre d'exemple, pour des couches 9 et 17 en SiCN ou en SiN, par exemple une couche 9 en SiCN et une couche 17 en SiN, la gravure, par exemple une gravure sèche, peut être une gravure à base de fluorocarbone, par exemple à base de C₄F₈.

La gravure de l'ouverture 43 est arrêtée sur la couche 17 recouvrant l'électrode 15, l'ouverture 43 passant alors par l'ouverture 35 gravée à l'étape de la figure 4, sans modifier les dimensions de l'ouverture 35 du fait que la gravure est sélective par rapport à la couche 9. L'ouverture 43 est donc gravée à travers la couche 37, et, lorsque la gravure décrite à l'étape de la figure 5 est arrêtée avant la couche 17, à travers une partie de la couche 7.

En outre, dans le cas où le circuit 1 comprend des vias 29, la gravure de chaque ouverture 43' est arrêtée sur la couche 9.

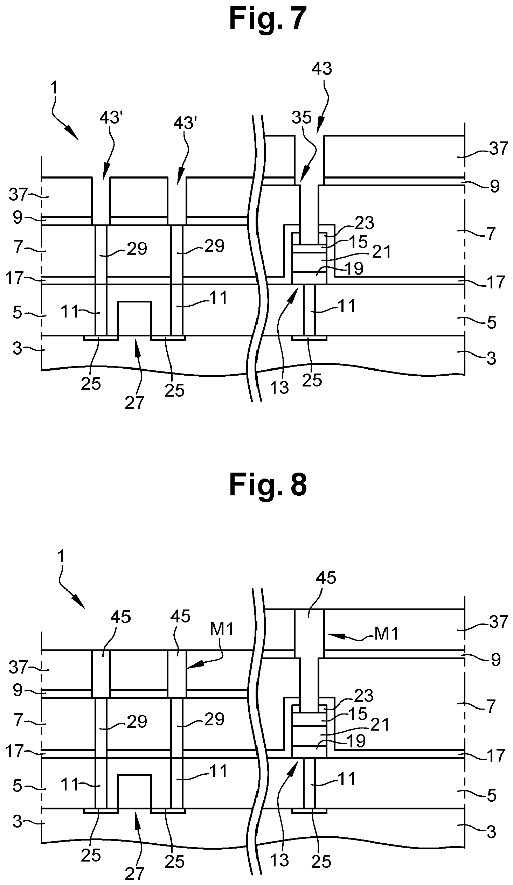

La figure 7 représente le circuit 1 de la figure 6 à une étape suivante du procédé.

A l'étape de la figure 7, la gravure de l'ouverture 43 est poursuivie jusqu'à l'électrode 15. En outre, dans le même temps, la gravure des ouvertures 43' est poursuivie jusqu'à ce que chaque ouverture 43' atteigne le sommet d'un via 29 correspondant. Dit autrement, la gravure de l'ouverture 43 est poursuivie à travers la couche 17 jusqu'à l'électrode 15, dans cet exemple en traversant la couche 23, et, lorsque le circuit 1 comprend des vias 29, la gravure des ouvertures 43' est simultanément poursuivie à travers la couche 9 jusqu'aux sommets des vias 29. Lors de la gravure de la figure 7, des portions de la couche 9 exposées lors de la gravure de l'ouverture 43 décrite en relation avec la figure 6 sont également gravées. Il en résulte que, comme cela est représenté en figure 7, l'ouverture 43 présente un épaulement défini par la couche 7, par exemple au niveau de la face supérieure de la couche 7. Dit autrement, la couche 7 forme un épaulement dans l'ouverture 43. Les dimensions de cet épaulement sont au moins en partie déterminées par les dimensions latérales de l'ouverture 35 gravée à l'étape de la figure 3. En outre, les dimensions de cet épaulement déterminent au moins en partie les dimensions latérales du fond de l'ouverture 43 au niveau de l'électrode 15.

Les étapes des figures 6 et 7 correspondent en pratique à une étape de gravure d'une ouverture 43 s'étendant depuis la face supérieure de la couche 37 jusqu'à l'électrode 15, et, dans le cas où le circuit comprend des vias 29, de gravure d'ouvertures 43' s'étendant depuis la face supérieure de la couche 37 jusqu'aux sommets de ces vias 29, cette étape de gravure étant ici mise en oeuvre par deux gravures successives.

La figure 8 représente le circuit 1 de la figure 7 à une étape suivante du procédé.

A cette étape, on forme le premier niveau de métal M1 de la structure d'interconnexion du circuit 1 en déposant au moins une couche métallique 45 de manière à remplir les ouvertures 43 et à recouvrir la couche 37, puis en effectuant une étape de planarisation par polissage mécano-chimique ou CMP ("Chemical Mechanical Polishing") jusqu'à la couche 37 de manière à retirer la partie de la couche 45 disposée au-dessus du niveau de la face supérieure de la couche 37.

A titre d'exemple, une seule couche 45 de cuivre est déposée à l'étape de la figure 8.

Le premier niveau de métal M1 de la structure d'interconnexion du circuit 1 ainsi obtenu comprend une portion (à droite en figure 8) disposée à l'aplomb de l'électrode 15. Cette portion du niveau de métal M1, qui remplit l'ouverture 43, s'étend depuis la face supérieure de la couche 37 jusqu'à l'électrode 15 avec laquelle elle est en contact, et repose en partie sur et en contact avec la couche 7, par exemple sur et en contact avec la face supérieure de la couche 7. Dit autrement, la portion du niveau de métal M1 disposée à l'aplomb de l'électrode 15 et remplissant l'ouverture 43 repose en partie sur l'épaulement formé par la couche 7 dans l'ouverture 43. Dit encore autrement, le niveau de métal M1 s'étend dans la couche 37 et comprend, au-dessus de l'électrode 15, une portion munie d'un prolongement qui s'étend à travers une ouverture 35 dans la couche 9, puis à travers la couche 7 jusqu'à l'électrode 15. Ce prolongement a, au niveau de l'épaulement formé par la couche 7 dans l'ouverture 43, par exemple au niveau de la face supérieure de la couche 7, des dimensions latérales, par exemple mesurées dans un plan parallèle à la face supérieure de la couche 3, qui sont plus faibles en dessous de l'épaulement qu'au-dessus de l'épaulement. Dit encore autrement, le niveau de métal M1 comprend une portion en contact avec l'électrode 15, cette portion comprenant une partie inférieure en contact avec l'électrode 15 et une partie supérieure traversant la couche 37 sur toute son épaisseur, la partie inférieure ayant, au niveau où elle est en contact avec la partie supérieure, des dimensions latérales plus faibles que celle de la partie supérieure, et la partie supérieure reposant en partie sur l'épaulement défini par la couche 7. Dans cet exemple, des portions latérales de la partie supérieure repose sur la couche 7.

Le niveau de métal M1 obtenu est en contact avec l'électrode 15 du composant 13.

En outre, dans le cas où le circuit 1 comprend des vias 29, le niveau de métal M1 est en contact avec les sommets de ces vias 29.

Le procédé se poursuit par des étapes (non illustrées) de formations des autres niveaux de métal de la structure d'interconnexion, par exemple lors d'étapes de dépôt, gravure, CMP de couches isolantes et de couches métalliques pour former ces autres niveaux de métal et des vias conducteurs reliant électriquement entre eux les niveaux de métal de la structure d'interconnexion. Ces étapes ultérieures sont à la portée de l'homme du métier.

Bien que l'on ait représenté en figure 1 à 8 un seul composant 13, en pratique le circuit 1 peut comprendre plusieurs composants 13, par exemple plusieurs milliers de composants 13 dans le cas où ces derniers sont des points mémoires. Dans ce cas, les étapes décrites en relation avec les figures 1 à 8 sont réalisées simultanément pour tous les composants 13 du circuit 1, le circuit 1 pouvant éventuellement comprendre des composants 13 différents. De manière similaire, le circuit 1 peut comprendre plusieurs composants 27, par exemple plusieurs milliers de composants 27. Dans ce cas, les étapes décrites en relation avec les figures 1 à 8 pour fabriquer le niveau de métal M1 en contact avec les vias 29 reliant électriquement, par l'intermédiaire des contacts 11, le niveau de métal M1 aux zones de contact 25 du composant 27 représenté sur ces figures 1 à 8, sont mises en oeuvre simultanément pour tous les vias 29 associés à ces composants 27.

Par ailleurs, bien que l'on ait décrit un seul circuit 1, en pratique plusieurs circuits 1 sont fabriqués simultanément à partir d'une même couche 3, l'ensemble de ces circuits 1 formant alors une plaquette de circuits 1. Les étapes décrites en relation avec les figures 1 à 8 sont alors de préférence mises en oeuvre simultanément pour tous les circuits 1 d'une même plaquette, puis, une fois la fabrication des circuits 1 et de leurs structures d'interconnexion terminée, les circuits 1 sont individualisés en découpant la plaquette. Dans ce cas, les étapes de dépôt de couches décrites précédemment sont réalisées sur toute la surface exposée de la plaquette, ces dépôts étant qualifiés de dépôts pleine plaque.

Dans le procédé décrit ci-dessus, les dimensions latérales de la portion du niveau de métal M1 au niveau de l'électrode 15 sont au moins en partie déterminées par les dimensions latérales de l'ouverture 35 gravée à l'étape de la figure 3. On aurait pu penser omettre l'étape de gravure de l'ouverture 35, et graver directement une ouverture depuis la face supérieure de la couche 37 jusqu'à l'électrode 15. Toutefois, l'ouverture obtenue de cette manière, sans gravure préalable de l'ouverture 35, aurait eu des dimensions latérales au niveau de l'électrode 15 qui auraient été plus grandes que celles de l'ouverture 43 obtenue par le procédé décrit en relation avec les figures 1 à 8. En particulier, l'ouverture gravée sans ouverture 35 préalable aurait pu déborder sur les flancs du composant 13, ce qui aurait conduit à former un niveau de métal M1 en contact avec l'électrode 15, mais aussi avec de couches sous-jacentes à l'électrode 15, court-circuitant ainsi ces couches du composant 13. Pour pallier ceci, on aurait pu penser augmenter les dimensions latérales de l'électrode 15, mais cela aurait conduit à une augmentation de la surface du circuit 1 ce qui n'est pas souhaitable. Ainsi, le procédé décrit en relation avec les figures 1 à 8 permet d'obtenir un niveau de métal M1 en contact avec une électrode 15 ayant des dimensions plus petites que si le procédé était mis en oeuvre sans l'étape de gravure de l'ouverture 35 décrite en relation avec la figure 3.

A titre d'exemple, les inventeurs ont constaté qu'avec le procédé décrit ci-dessus en relation avec les figures 1 à 8, il est possible de graver une ouverture 43 dont le fond a, au niveau d'une électrode 15 correspondante, des dimensions latérales minimales inférieures à 40 nm, par exemple égales ou sensiblement égales à 30 nm, ce qui permet que l'électrode 35 ait des dimensions latérales correspondantes par exemple inférieures à 60 nm, par exemple égales ou sensiblement égales à 50 nm.

En outre, dans le procédé décrit en relation avec les figures 1 à 8, à l'étape de gravure de l'ouverture 43 (figures 6 et 7) jusqu'à l'électrode 15, il n'est pas nécessaire que l'ouverture 41 du masque 39 à partir de laquelle est gravée l'ouverture 43 soit parfaitement alignée sur l'électrode 15, du fait que l'ouverture 35 permet de rattraper une éventuelle erreur d'alignement. Ce n'aurait pas été le cas sans ouverture 35 préalable, du fait que l'ouverture gravée aurait alors pu découvrir les flancs du composant 13.

Par ailleurs, plutôt que de fabriquer le niveau de métal M1 en contact avec l'électrode 15 du composant 13, on aurait pu penser, lors de la formation des vias 29, à former simultanément un via 29 supplémentaire dont la base aurait été en contact avec l'électrode 15 et dont le sommet aurait affleuré la face supérieure de la couche 7. Toutefois, par rapport au procédé décrit en relation avec les figures 1 à 8, cela aurait nécessité une plus grande épaisseur de couche 7 entre le composant 13 et la couche 9, ce qui aurait conduit à des vias 29 plus long et donc à des capacités parasites plus importantes, notamment pour les vias 29 permettant de relier électriquement les zones 25 de composants 27 au niveau de métal M1, ce qui n'est pas souhaitable.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, bien que l'on ait décrit en relation avec les figures 1 à 8 un exemple dans lequel le composant 13 est un point mémoire tel qu'un point mémoire d'une mémoire à changement de phase, le procédé décrit peut être mis en oeuvre avec d'autres composants comprenant une région de contact située à un niveau intermédiaire entre le niveau des sommets des vias de contact 11 et la couche 9 sur laquelle reposera le premier niveau de métal M1 d'une structure d'interconnexion du circuit, par exemple un point mémoire d'une mémoire de type magnétique ou d'une mémoire résistive à base d'oxyde ou un composant autre qu'un point mémoire. En outre, l'homme du métier est mesure de modifier les divers matériaux indiqués ci-dessus à titre d'exemple en adaptant le procédé décrit, notamment pour respecter les sélectivités de gravures décrites.

Enfin, la mise en oeuvre pratique des modes de réalisation et variantes décrits est à la portée de l'homme du métier à partir des indications fonctionnelles données ci-dessus.

## Revendications

1. Procédé de fabrication d'une structure d'interconnexion comprenant les étapes successives suivantes :
a) prévoir un circuit intégré (1) comprenant : une première couche isolante (5) ; une deuxième couche isolante (7) reposant sur la première couche ; une troisième couche isolante (9) reposant sur la deuxième couche ; des vias de contact électrique (11) traversant la première couche (5) ; des premiers vias électriquement conducteurs (29) traversant la deuxième couche isolante (7) et s'étendant depuis un via de contact électrique (11) correspondant jusqu'à ladite troisième couche (9) ; et un point mémoire (13) d'une mémoire à changement de phase, une région de contact électrique (15) du point mémoire étant située dans la deuxième couche (7) et étant recouverte par une partie de cette deuxième couche (7) ;
b) graver une première ouverture (35) à travers la troisième couche (9) et à l'aplomb de la région de contact (15), la gravure de la première ouverture (35) étant stoppée avant la région de contact (15) ;
c) déposer une quatrième couche isolante (37) de sorte à remplir la première ouverture (35) et à recouvrir la troisième couche (9) ;
d) graver une deuxième ouverture (43) à travers la quatrième couche (37) jusqu'à la région de contact (15) de sorte que la deuxième ouverture (43) passe à travers la troisième couche isolante (9) au niveau de la première ouverture (35) ; et
e) former un niveau de métal (M1) de la structure d'interconnexion en remplissant la deuxième ouverture d'au moins un métal (45).

2. Procédé selon la revendication 1, dans lequel, à l'étape a), les vias de contact électrique (11) ont des sommets situés en dessous de la deuxième couche isolante (7).

3. Procédé selon la revendication 1 ou 2, dans lequel des troisièmes ouvertures (43') sont gravées en même temps que la deuxième ouverture (43) à l'étape d), chaque troisième ouverture (43') étant gravée à l'aplomb d'un des premiers vias (29) et jusqu'audit premier via (29).

4. Procédé selon la revendication 3, dans lequel l'étape d) comprend le dépôt d'une première couche de résine photosensible et l'alignement d'un masque d'insolation de la première couche de résine avec lesdits premiers vias (29) .

5. Procédé selon l'une quelconque des revendications 1 à 4, dans lequel, à l'étape a), une cinquième couche isolante (17) recouvre la région de contact (15), et, à l'étape d), la gravure de la deuxième ouverture (43) comprend une première gravure jusqu'à ladite cinquième couche (17) suivie d'une deuxième gravure à travers la cinquième couche et jusqu'à la région de contact (15).

6. Procédé selon la revendication 5, dans lequel la première gravure est sélective par rapport à la troisième couche isolante (9) et à la cinquième couche isolante (17).

7. Procédé selon les revendications 3 et 5, dans lequel, à l'étape d), les troisièmes ouvertures (43') sont gravées jusqu'à la troisième couche (9) lors de la première gravure, puis jusqu'aux premiers vias (29) lors de la deuxième gravure.

8. Procédé selon l'une quelconque des revendications 1 à 7, dans lequel l'étape b) comprend le dépôt d'une deuxième couche de résine photosensible et l'alignement d'un masque d'insolation de la deuxième couche de résine avec ladite région de contact (15).

9. Procédé selon l'une quelconque des revendications 1 à 8, dans lequel la première ouverture (35) à des dimensions latérales inférieures à des dimensions latérales correspondantes de la région de contact (15).

10. Procédé selon l'une quelconque des revendications 1 à 9, dans lequel l'étape e) comprend le dépôt dudit au moins un métal (45) de manière à remplir la deuxième ouverture (43) et à recouvrir la quatrième couche isolante (37), et une étape de polissage mécano chimique jusqu'à la quatrième couche isolante.

11. Procédé selon l'une quelconque des revendications 1 à 10, dans lequel, à l'étape a), la première couche isolante (5) repose sur une couche semiconductrice (3), de préférence munie de zones de contact électrique (25) en contact avec des vias de contact électrique (11) correspondants.

12. Procédé selon l'une quelconque des revendications 1 à 11, dans lequel, à l'étape a), la région de contact électrique (15) du point mémoire (13) est une région de contact supérieure, le point mémoire comprenant en outre une région de contact inférieure (19) située à l'aplomb de la région de contact supérieure (15), la région de contact inférieure étant en contact avec un sommet d'un desdits vias de contact électrique (11).

13. Circuit intégré (1) comprenant :
une première couche isolante (5) ;
une deuxième couche isolante (7) reposant sur la première couche (5) ;
une troisième couche isolante (9) reposant sur la deuxième couche (7) ;
des vias de contact électriques (11) traversant la première couche (5) ;
un point mémoire (13) d'une mémoire à changement de phase, le point mémoire (13) comprenant une région de contact électrique supérieure (15) située dans la deuxième couche (7) en dessous de la face supérieure de la couche (7), et une région de contact électrique inférieure (19) en contact avec un sommet d'un des vias de contact électrique (11) ;
une quatrième couche isolante (37) reposant sur une face supérieure de la troisième couche isolante (9) ; et
un premier niveau de métal (M1) d'une structure d'interconnexion du circuit (1) comprenant une portion s'étendant depuis une face supérieure de la quatrième couche (37) jusqu'à la région de contact électrique supérieure (15) et reposant en partie sur et en contact avec la deuxième couche isolante (7), de préférence sur et en contact avec un épaulement défini par la deuxième couche isolante, le premier niveau de métal (M1) étant le niveau de métal de la structure d'interconnexion le plus proche d'une couche semiconductrice (3) du circuit (1).

14. Circuit selon la revendication 13, dans lequel ledit premier niveau de métal (M1) est obtenu en mettant en oeuvre le procédé selon l'une quelconque des revendications 1 à 12.
